# EUROPEAN PATENT APPLICATION

(11) **EP 2 757 357 A2**
(43) Date of publication of application: **23.07.2014**
(21) Application number: 13189011.3
(22) Date of filing: 16.10.2013
(51) Int. Cl.: G01K 7/24

(54) **Systems and methods for an auto-ranging temperature sensor**

(30) Priority: 17.01.2013 US 201313743890
(71) Applicant: Honeywell International Inc., Morristown, NJ 07962-2245 (US)
(72) Inventor: Sundstrom, Lance LeRoy, Morristown, NJ 07962-2245 (US); Kirkpatrick, Shane Michael, Morristown, NJ 07962-2245 (US); Parmet, Darryl I., Morristown, NJ 07962-2245 (US)
(74) Representative: Houghton, Mark Phillip

(57) **Abstract**

Systems and methods for an auto-ranging temperature sensor are provided. In at least one embodiment, a system for sensing and measuring temperature comprises at least one analog signal amplifier that generates an amplified analog signal output based on an analog signal from at least one of a biased thermistor circuit and a calibration circuit and a digital to analog converter that generates an analog offset signal as an input to the at least one analog signal amplifier, wherein the analog offset signal shifts the amplified analog signal within an analog to digital converter input operating range when the amplified analog signal is equal to or greater than a limit of the analog to digital converter input operating range, wherein the analog offset signal is determined based on the magnitude of the amplified analog signal.

## Description

This invention was made with Government support under contract FA9453-08-C-0162 awarded by the Air Force Research Lab. The Government may have certain rights in the invention.

### BACKGROUND

A thermistor is a resistor whose resistivity varies with temperature with a specific, precise and repeatable resistance versus temperature relationship. As such, thermistors are frequently implemented in temperature sensing and measurement systems. To sense the temperature, the thermistor is typically biased with a voltage or a current to generate a temperature-dependent analog signal that is converted into a digital signal (with a binary value) by an analog to digital (A/D) converter. The converted temperature-dependent analog signal from the A/D converter is then processed to determine the thermistor resistance, which is then converted into a temperature result. However, the range and resolution of the temperature result is limited by the range & resolution of the A/D converter. For example, over a temperature range of 10 degrees Celsius (°C.), a 14-bit A/D converter will only provide a resolution of (10/2¹⁴ = 10/16384)°C, or about 610 micro degrees Celsius (µ°C).

In certain applications and implementations, higher resolution temperature measurements over the same, similar or larger temperature ranges can be acquired using the same A/D converter through a range selection method. The range selection adjusts the amplified temperature-dependent signal to keep the adjusted analog signal within a desired input range for the A/D converter. In certain applications and implementations, the temperature sensor achieves the desired range and resolution through the use of fixed high gain analog amplifier circuits and fixed range select circuits. In such applications and implementations, however, the combination of high gain analog amplifier and range select circuits and discrete component value and active device parameter tolerances, such as analog multiplexor and operational amplifier input and output voltage and current offsets, can negatively affect the operation, performance and reliability of the temperature sensor and measurement system.

### SUMMARY

Systems and methods for an auto-ranging temperature sensor are provided. In at least one embodiment, a system for sensing and measuring temperature comprises at least one analog signal amplifier that generates an amplified analog signal output based on an analog signal from at least one of a biased thermistor circuit and a calibration circuit and a digital to analog converter that generates an analog offset signal as an input to the at least one analog signal amplifier, wherein the analog offset signal shifts the amplified analog signal within an analog to digital converter input operating range when the amplified analog signal is equal to or greater than a limit of the analog to digital converter input operating range, wherein the analog offset signal is determined based on the magnitude of the amplified analog signal.

### DRAWINGS

Understanding that the drawings depict only exemplary embodiments and are not therefore to be considered limiting in scope, the exemplary embodiments will be described with additional specificity and detail through the use of the accompanying drawings, in which:

Figure 1 is a block diagram of a system for an auto-ranging temperature sensor in one embodiment described in the present disclosure;

Figure 2 is a schematic of a system for an auto-ranging temperature sensor in one embodiment described in the present disclosure;

Figure 3 is a graph of an auto-ranged analog A/D input signal, wherein the analog signal is an analog voltage, in one embodiment described in the present disclosure; and

Figure 4 is a flow diagram of a method for auto-ranging a temperature sensor and measurement system in one embodiment described in the present disclosure.

In accordance with common practice, the various described features are not drawn to scale but are drawn to emphasize specific features relevant to the exemplary embodiments.

### DETAILED DESCRIPTION

In the following detailed description, reference is made to the accompanying drawings that form a part hereof, and in which is shown by way of illustration specific illustrative embodiments. However, it is to be understood that other embodiments may be utilized and that logical, mechanical, and electrical changes may be made without departing from or exceeding the scope of the present invention. Furthermore, the method presented in the drawing figures and the specification is not to be construed as limiting the order in which the individual steps may be performed. The following detailed description is, therefore, not to be taken in a limiting sense.

Embodiments of the present invention address the limitations that existing thermistor or other temperature sensing device based temperature sensing and measurement systems face when attempting to meet the conflicting requirements of wide temperature range and high temperature resolution that include such challenges as the inherent integral nonlinearity of A/D converters and active device parametric and discrete component value tolerances and variations over time, temperature and radiation. Embodiments of the present invention provide systems and methods to perform calibrated temperature sensing and measurements with high precision and across a broad temperature range. Also, embodiments of the present invention select components and scale component values and supporting software such that it is suitable for use over a broader temperature range or achieves a higher resolution within the range or both.

In certain embodiments, a digital to analog (D/A) converter device is coupled to an analog signal amplifier that amplifies the temperature-dependent analog signal. The D/A converter provides an adjustable analog offset that can maintain the amplified temperature-dependent analog signal provided to the A/D converter within the desired input operating range of the A/D converter. Also, a signal from a calibration circuit that replicates the equivalent of a biased thermistor circuit at a specific temperature is provided for circuit and system calibration. This is typically done by replacing the thermistor of a biased thermistor circuit of one analog multiplexor channel with a resistor with a resistance equal to the thermistor resistance at a specific temperature. The D/A converter and calibration circuits provide the flexibility and resolution to compensate for passive and active component parameter variations such as initial tolerances, aging, radiation, temperature, and their effects on thermistor path selection, temperature sensing and measurement relative to a calibration temperature, typically at the center of the desired temperature range, thus improving system temperature sensing and measurement accuracy, repeatability and long term reliability.

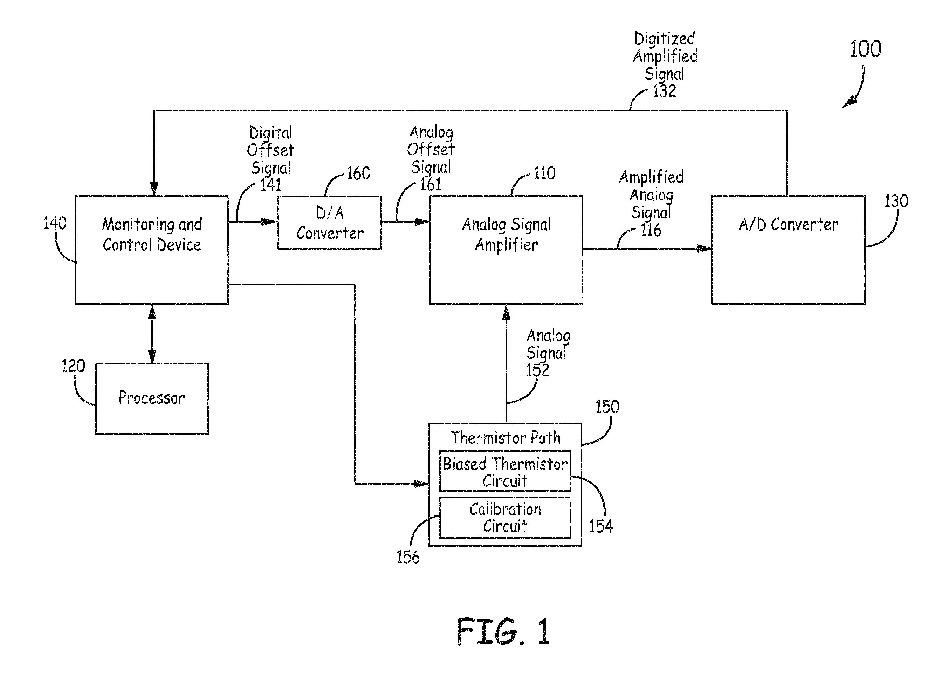

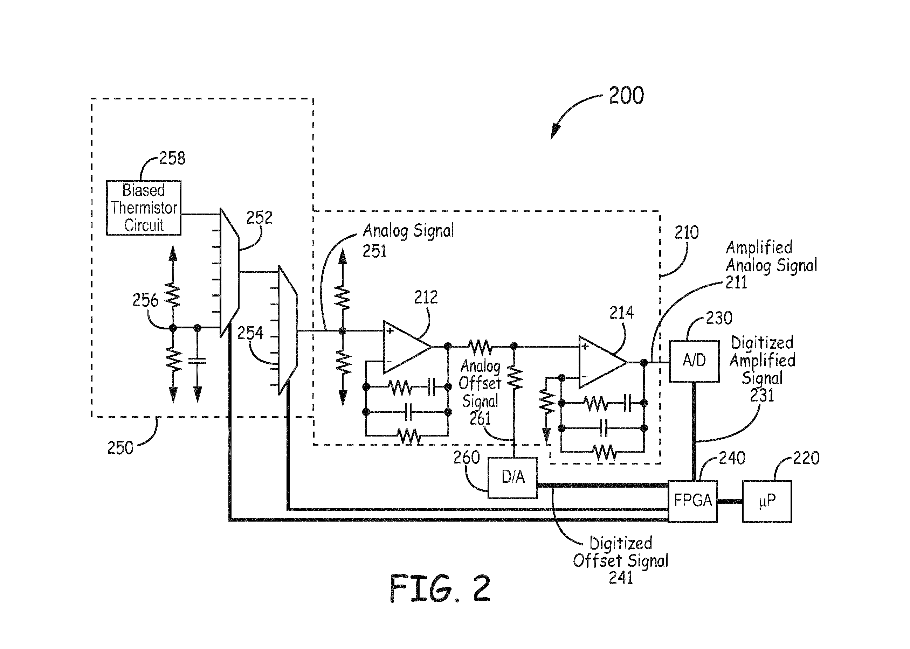

Figure 1 is a block diagram of one embodiment of a system 100 for high resolution temperature sensing and measurement over a wide temperature range. The system 100 comprises an analog signal amplifier 110, an A/D converter 130, a D/A converter 160, a monitoring and control device 140, a processor 120, and a thermistor path 150 for selecting one of multiple biased thermistor or calibration circuits and performing initial and periodic calibration and precise temperature measurements over a wide temperature range (for example, 5 °C). The thermistor path 150 includes at least one biased thermistor circuit 154, at least one calibration circuit 156 and at least one analog multiplexor for selecting between them (shown in Figure 2). The thermistor path 150 outputs analog signal 152 from the selected biased thermistor circuit 154 or calibration circuit 156 to the analog signal amplifier 110. The biased thermistor circuit 154 in thermistor path 150 can sense the temperature within or around any object. For example, the biased thermistor circuit 154 in thermistor path 150 can sense the temperature in a system that includes a temperature-sensitive device (such as an inertial sensor unit), electrical equipment, or any other system or apparatus where a high resolution temperature measurement is desired. In certain applications and implementations, a biased thermistor circuit 154 may be included in each of multiple different locations within or around a system. When there are multiple biased thermistor circuits 154, the monitoring and control device 140 can select one of multiple different biased thermistor circuits 154 via one or more analog multiplexors to sense temperature at the different locations within or around the system. Further, to calibrate the system 100, one channel of each analog multiplexor chain includes a calibration circuit 156. The calibration circuit 156 provides a reference signal representing the equivalent of a biased thermistor circuit at a specific temperature for that analog multiplexor chain. This provides a means for calibrating the system for each multiplexor chain to compensate for component parameter tolerances and variations such as multiplexor device input/output leakages/offsets and on/off resistances.

Signal amplifier 110 receives the analog sum of a biased thermistor circuit 154 or calibration circuit 156 analog signal 152 from thermistor path 150 and an analog offset signal 161 from D/A converter 160 and outputs an amplified analog signal 116 derived from the analog sum signal. The amplified analog signal 116 is representative of the portion of the analog signal 152 from biased thermistor 154 or calibration circuit 156 in the thermistor path 150 that is not offset by the analog offset signal 161 from D/A converter 160 and is within an input operating range of the A/D converter 130.

The A/D converter 130 digitizes amplified analog signal 116 into a digitized amplified signal 132. A/D converter 130 functions over a specific input range (referred to herein as the maximum input operating range of A/D converter 130) and converts an amplified analog signal 116 into a digitized amplified signal 132 which represents the analog signal as a digital word comprising a predetermined number of bits. Each digital word can be broken down into a most significant bit and a least significant bit. The temperature value represented by the digital word's least significant bit (LSB) determines the system temperature resolution that A/D converter 130 can provide. When the digitized amplified signal 132 output of A/D converter 130 is interpreted as a temperature value, the breadth of the maximum temperature range that A/D converter 130 functions over is limited by the LSB multiplied by 2", where n is the number of bits in each digital sample that the A/D converter 130 outputs. The desired input operating range of the A/D converter 130 is typically limited to less than its maximum input operating to avoid range limit or accuracy errors.

In order to effectively expand the operating range of the system 100 using A/D converter 130, the analog signal amplifier 110 is coupled to the D/A converter 160. The D/A converter 160 provides an analog offset signal 161 to the analog signal amplifier 110 that offsets the amplified analog signal 116 such that the amplified analog signal 116 remains within the desired operating range of the A/D converter 130 over a larger temperature range. For example, the monitoring and control device 140 receives a digitized amplified signal 132 from the A/D converter 130, depending on the value of the digitized amplified signal 132, the processor 120 and associated software determine whether the A/D converter 130 is operating near the desired input operational limits of the A/D converter 130. If the A/D converter 130 is operating near a desired input operational limit, the processor 120 commands the monitoring and control device 140 to adjust the digital offset signal 141 to the D/A converter 160. The D/A converter 160 converts the digital offset signal to an analog offset signal 161 provided to the analog signal amplifier 110. The analog offset signal 161 shifts the amplified analog signal 116 such that the amplified analog signal 116 remains within the desired input operating range of the A/D converter 130. A key feature of the invention is that the amplified analog signal 116 is the amplified portion of analog signal 152 that is not offset by analog offset signal 161. As such, the digitized amplified signal 132 represents the fine temperature offset from the coarse temperature represented by the magnitude of digital offset signal 141 adjusted by its digital calibration reference signal. The actual temperature measurement is then derived from the combination of digital offset signal 141 value, digital calibration reference value for that multiplexor chain and the digitized amplified signal 132 value. It is the high resolution of the D/A converter that enables it to perform both calibration and range stepping functions.

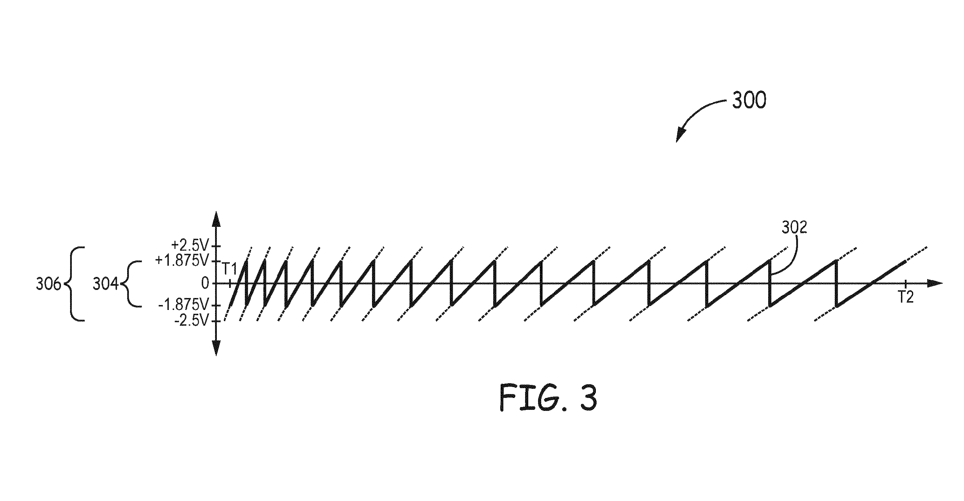

In one implementation, where the A/D converter 130 has an upper desired input threshold and a lower desired input threshold, the monitoring and control device 140 as controlled by the processor 120 and software command monitoring and control device 140 to change the analog offset signal 161 provided by the D/A converter 160 depending on whether the temperature sensed by a biased thermistor circuit 154 in a thermistor path 150 is rising or falling. When the temperature sensed by the biased thermistor circuit 154 is falling, the amplified analog signal 116 provided to the A/D converter 130 will approach the lower desired input threshold. When the amplified analog signal 116 reaches or is less than the lower desired input threshold, the processor 120 and software command the monitoring and control device 140 to adjust the digital offset signal 141 to the D/A converter 160 to shift its analog offset signal 161 such that the amplified analog signal 116 is shifted from the lower desired input threshold to the upper desired input threshold. Conversely, when the temperature sensed by the biased thermistor circuit 154 is rising, the amplified analog signal 116 provided to the A/D converter 130 will approach the upper desired input threshold. When the amplified analog signal 116 reaches or exceeds the upper desired input threshold, the processor 120 and software command the monitoring and control device 140 to adjust the digital offset signal 141 to the D/A converter 160 to shift its analog offset signal 161 such that the amplified analog signal 116 is shifted from the upper desired input threshold to the lower desired input threshold. By automatically shifting the amplified analog signal 116, the processor 120, software and monitoring and control device 140 are able to efficiently maintain the amplified analog signal 116 within a desired operational input range for the A/D converter 130 and thereby effectively auto-range across a wide temperature range as further described below in relation to Figure 3.

In at least one embodiment, the calibration circuit 156 is used to calibrate the combination of the D/A converter 160, the analog signal amplifier 110, the A/D converter 130 and the biased thermistor circuits 154 and thermistor paths 150 associated with a specific multiplexor chain (all paths that include the same combination of multiplexor devices). It should be noted here that analog multiplexor parasitic parameters, such as on/off impedances and input/output offset/leakage currents, are much better matched channel to channel within the same device than from part to part. Since the input/output offset/leakage currents can exceed the LSB delta signals of biased thermistor circuits, each unique multiplexor chain may need to be compensated. For example, the D/A converter 160 receives a digital offset signal 141 that it converts into an analog offset signal 161 for the analog signal amplifier 110. To calibrate this portion of the system, the processor 120 and software commands the monitoring and control device 140 to select the calibration circuit 156 in the thermistor path 150, which calibration circuit 156 provides an analog signal 152 to the analog signal amplifier 110 that is equivalent to a biased thermistor circuit 154 at a specific reference calibration temperature (typically the midpoint of the temperature range). The processor 120 and software then commands monitoring and control device 140 to adjust the digital offset signal 141 sent to the D/A converter 160 until the A/D converter 130 digitized amplified signal 132 is as close as possible to a 0 value. The values of the digital offset signal 141 and digitized amplified signal 132 are then stored as the calibration digital word for that reference temperature and that portion of the system. Temperature measurements in that portion of the system are then calculated relative to the digital offset signal 141 and digitized amplified signal 132 values at the reference calibration temperature. This compensates for all passive discrete and active device parametric value variations in that portion of the system. In certain embodiments, where there are multiple calibration circuits 156 (each group of thermistor paths that includes a unique combination of analog multiplexor devices, i.e. each unique multiplexor chain), the monitoring and control device 140, processor 120 and associated software selects and performs the above described calibration procedure for each portion of the system associated with a calibration circuit 156.

As stated above, the A/D converter 130 digitizes the amplified analog signal 116 and provides a digitized amplified signal 132 to the monitoring and control device 140. The monitoring and control device 140 provides the digitized amplified signal 132 to the processor 120. To implement the monitoring and control device 140 and the processor 120, the system 100 may include any of several means. These means include, but are not limited to, digital computer systems, microprocessors, general purpose computers, programmable controllers and field programmable gate arrays (FPGAs). For example, in one embodiment, monitoring and control device 140 is implemented by an FPGA or both monitoring and control device 140 and processor 120 are implemented with an ASIC, with an embedded processor. Therefore, other embodiments of the present invention are program instructions resident on computer readable media which when implemented by such means enable them to implement embodiments of the present invention. Computer readable media or storage media includes any form of a physical computer memory device. Examples of such a physical computer memory device include, but are not limited to, punch cards, magnetic disks or tapes, optical data storage system, flash read only memory (ROM), non-volatile ROM (NVRAM), programmable ROM (PROM), erasable-programmable ROM (EPROM), random access memory (RAM), or any other form of permanent, semi-permanent, or temporary memory storage system or device. Program instructions include, but are not limited to computer-executable instructions executed by computer system processors and hardware description languages such as Very High Speed Integrated Circuit (VHSIC) Hardware Description Language (VHDL). Combinations of the above are also included within the scope of computer readable media. Furthermore, AC power, DC power, or combinations thereof can be implemented in embodiments of the present invention.

Figure 2 is a circuit diagram of one embodiment of system 200 that implements system 100 of Figure 1 as described above. In certain embodiments, system 200 includes a thermistor path 250, an analog signal amplifier 210, an A/D converter 230, a D/A converter 260, a monitoring and control device 240, and a processor 220 that function like the thermistor path 150, the signal amplifier 110, the A/D converter 130, the D/A converter 160, the monitoring and control device 140, and the processor 120 described in relation to system 100 in Figure 1. To control the operation of the system 200, the processor 220 receives system status updates and temperature data from the monitoring and control device 240. The processor 220 also provides commands to the monitoring and control device 240 to control the operation of portions of system 200. In at least one embodiment, the monitoring and control device 240 is implemented as an FPGA.

In certain embodiments, the monitoring and control device 240 controls and monitors the thermistor path 250. In certain implementations, the thermistor path 250 functions as thermistor path 150 in Figure 1. The thermistor path 250 includes multiple biased thermistor circuits 258 that are placed at different locations around a monitored system. For example, the thermistor path 250 includes multiple biased thermistor circuits 258 placed at different locations around an inertial measurement unit. In at least one embodiment, the multiple biased thermistor circuits 258 are connected to a series of analog multiplexors that includes a first analog multiplexor layer 252 and a second analog multiplexor 254, wherein the first analog multiplexor layer 252 is connected to the second analog multiplexor layer 254. For example, each output of multiple analog multiplexors of the first analog multiplexor layer 252, each having eight inputs, may be connected to a separate input of analog multiplexor of analog multiplexor layer 254, each having eight inputs, wherein each of seven of the eight inputs of each analog multiplexor of first analog multiplexor layer 252 is connected to different biased thermistor circuit 258. The other input of the eight inputs of each analog multiplexor of first analog multiplexor layer 252 may be connected to a calibration circuit 256, wherein the calibration circuit 256 is equivalent to a biased thermistor circuit 258 at a specific temperature such as described above in relation to calibration circuit 156. A calibration circuit 256 provides an analog signal equivalent to that of a biased thermistor circuit 258 at a specific temperature for each analog multiplexor in the first analog multiplexor layer 252. Each of multiple analog multiplexor outputs of the first analog multiplexor layer 252 are also connected to a different inputs of an analog multiplexor of second multiplexor layer 254. For example, when there are eight analog multiplexors in the first analog multiplexor layer 252, each first analog multiplexor layer 254 output may connect to a separate input of a common analog multiplexor of second analog multiplexor layer 254. As such and by extension, multiple biased thermistor circuits 258 can fan in through one or multiple multiplexor layers to one or more shared common D/A, signal amplifier and A/D circuit resources with a calibration circuit 256 for each unique multiplexor chain.

The first analog multiplexor layer 252 and the second analog multiplexor 254 allow the processor 220 and the monitoring and control device 240 to control selection of which of multiple biased thermistor circuits 258, in the thermistor path 250, provides an analog signal 251 to be amplified by the analog signal amplifier 210. Further, the first analog multiplexor layer 252 and the second analog multiplexor 254 allow the processor 220 and the monitoring and control device 240 to control selection of the calibration circuit 256 of the thermistor path 250. For example, when calibrating a system and a unique multiplexor chain comprised of a multiplexor in the first multiplexor layer 252 and a multiplexor in the second multiplexor layer 254, a separate calibration circuit 256 analog signal 251 is passed through the analog multiplexors of first analog multiplexor layer 252 and second analog multiplexor layer 254 to the analog signal amplifier 210 for amplification and then passed to the A/D converter 230 for conversion to a digitized amplified signal 232 that is monitored by the monitoring and control device 240. To calibrate the system 200, the monitoring and control device 240 adjusts the digital offset signal 242 sent to the D/A converter 260 until the A/D converter 230 outputs a digitized amplified signal 232 having a desired value. For example, the monitoring and control device 240 adjusts the digital offset signal 242 sent to the D/A converter 260 until the A/D converter 230 outputs a digitized amplified signal having a value as close as possible to 0. The monitoring and control device 240 calibrates the system 200 for each multiplexor chain via the calibration circuits 256 of each multiplexor chain in this manner. The digital offset signal 242 and the digitized amplified signal values from each calibration circuit 256 are stored as the system calibration value for that multiplexor chain and temperature. All temperature measurements via the biased thermistor circuits 258 are then calculated with respect to the calibration value for that multiplexor chain. This compensates for all component parameter tolerances and variations and calibrates each multiplexor chain to a specific temperature. The system can be recalibrated periodically to compensate for component parameter variations over time and thereby maintain system accuracy.

When a biased thermistor circuit 258 provides an analog signal 251 to the analog signal amplifiers 210, the analog signal amplifiers 210 amplify the analog signal 251 before it is converted to digitized amplified signal 231 by the A/D converter 230. In certain implementations, the A/D converter 230 is only able to convert analog signals to a digital signal when the analog signal is within a specific range. For example, the A/D converter 230 may have two different input ranges. A first input range can represent the maximum input range that the A/D converter 230 is able to handle. A second input range can be smaller than the first input range but can represent an input range over which the A/D converter 230 has increased accuracy. For instance, an A/D converter 230 may be able to receive input signals within a first input range of ±2.5V but have a second smaller input range of ±1.875V where the A/D converter 230 operates more accurately. To increase the precision of the temperature sensing and measurement, the analog signal amplifiers 210 amplify the analog signal 251 provided from the thermistor path 250, however, the amplification may cause the amplitude of the amplified analog signal 211 to exceed the desired input operating range of the A/D converter 230.

In certain embodiments, to keep the amplified analog signal 211 within the desired operating range of the A/D converter 230, the system 200 includes the D/A converter 260. The D/A converter 260 is coupled to the analog signal amplifier 210 and provides an analog offset signal 261 that offsets the analog signal 251 from thermistor path 250 such that the amplified analog signal 211 provided by the analog signal amplifier 210 to the A/D converter 230 are within an input operating range. In at least one exemplary embodiment, the analog signal amplifier 210 includes a first analog signal amplifier 212 stage and a second analog signal amplifier 214 stage. The D/A converter 260 is coupled to a summing junction, comprised of two resistors, between the first analog signal amplifier stage 212 and the second analog signal amplifier stage 214 and offsets the input to the second analog signal amplifier stage 214 such that the amplified analog signal 211 output of the second analog signal amplifier stage 214 is within the desired operational range for accurate operation of the A/D converter 230. The summing junction sums the amplified analog signal output of first analog signal amplifier 212 and the analog offset signal 261 output of D/A converter 260.

Figure 3 is a graph 300 that illustrates how the amplified analog signal 211, depicted here as analog voltage signal 302, that is provided to the A/D converter 230 input by the analog signal amplifiers 210 changes to maintain the analog voltage signal 302 within the desired input operational voltage range of A/D converter 230. The graph 300 includes two separate output voltage ranges that correspond to a first input voltage range 306 (i.e. ±2.5V) and a second input voltage range 304 (i.e. ±1.875V). As is described above, the first input voltage range 306 corresponds to the maximum input voltage range for the A/D converter 230 and the second input voltage range 304 corresponds to a desired operational input voltage range over which the A/D converter 230 is more accurate. The graph 300 illustrates the analog voltage signal 302 to the A/D converter 230 input over a temperature range between temperatures T1 and T2. The D/A converter 260 functions to maintain the analog voltage signal 302 within the second input voltage range 304 by providing an analog offset signal 261 that offsets the analog voltage signal within the analog signal amplifier 210. For example, when the analog voltage 302 is rising and reaches or exceeds the upper limit of the second input voltage range 304, the D/A converter 260 offsets the analog voltage within the analog signal amplifiers 210 in such a way that the analog voltage 302 shifts to the lower limit of the second input voltage range 304. Conversely, when the analog voltage 302 is decreasing and reaches or is less than the lower limit of the second input voltage range 304, the D/A converter 260 offsets the analog voltage within the analog signal amplifier 210 in such a way that the analog voltage 302 shifts to the upper limit of the second input voltage range 304.

In at least one implementation, the system 200 uses the temperature measured before an offset shift to determine the temperature after an offset shift. For example, when the monitoring and control device 240 sends a digital offset signal 241 to the D/A converter 260 that shifts the amplified analog signal 211 from the upper input voltage limit to the lower input voltage limit of A/D converter 230, the system 200 associates the digital offset signal 241 and digitized amplified signal 231 from the voltage at the lower limit after the shift and from the voltage at the upper limit before the shift with the same temperature. Likewise, when the monitoring and control device 240 sends a digital offset signal 241 to the D/A converter 260 that shifts the amplified analog signal 211 from the lower input voltage limit to the upper input voltage limit of A/D converter 230, the system 200 associates the digital offset signal 241 and digitized amplified signal 231 from the voltage at the upper limit after the shift and from the voltage at the lower limit before the shift with the same temperature. By shifting the analog voltage 302 within the second input voltage range 304, the system 200 is able to precisely sense and measure a wide temperature range within the more accurate voltage range of the A/D converter 230.

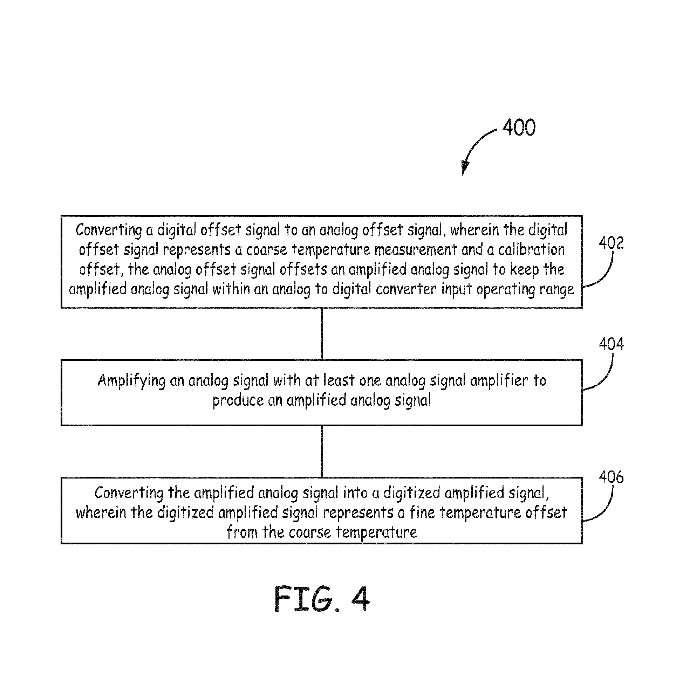

Figure 4 is a flow diagram of a thermistor based method 400 for calibrating, sensing and measuring temperature in a system. Method 400 proceeds at 402 wherein the digital offset signal represents a coarse temperature measurement and a calibration offset, the analog offset signal offsets an amplified analog signal to keep the amplified analog signal within an analog to digital converter input operating range. For example, a monitoring and control device 240 sequentially selects the calibration circuit 256 of each analog multiplexor chain and adjusts its digital offset signal 241 to a D/A converter 260 for an analog offset signal 261 1 that produces a digitized amplified signal 231 as close as possible to a zero value and stores the digital offset signal 241 and digitized amplified signal 231 values as the coarse and fine calibration reference temperature value pairs, respectively, from which the temperature of the biased thermistor circuits 258 of the same multiplexor chain are sensed and measured. Each biased thermistor circuit 258 analog signal 251 is also offset by the D/A converter 260 to keep the amplified analog signal 211 within an input operating range of A/D converter 230 by providing the analog offset signal 241 from a D/A converter 240 to the at least one analog signal amplifier 210. In certain embodiments, an A/D converter can have an input operating range through which the A/D converter more accurately converts analog signals to digital signals. To keep the amplified analog signal 211 within the A/D converter input operating range, a monitoring and control device 240 monitors either the digitized amplified signal 231 or the amplified analog signal 211 to determine an analog offset signal 261 that will offset the amplified analog signal 211 to maintain the amplified analog signal 211 within the A/D converter input operating range.

Method 400 proceeds at 404 where an analog signal is amplified by at least one analog signal amplifier to produce an amplified analog signal 211. In at least one implementation, the analog signal is produced by either a biased thermistor circuit 258 or by a calibration circuit 256 that replicates a biased thermistor circuit at a specific temperature. For example, multiple biased thermistor circuits 258 can be placed to sense temperatures at different locations within or around an electronic device. Each biased thermistor circuit 258 provides an independent temperature-sensitive signal, where the biased thermistor circuit 258 or calibration circuit 256 signals are selectable through an analog multiplexor network. When a temperature-sensitive or temperature reference signal is selected, a single or series of analog signal amplifiers can amplify the temperature-sensitive or temperature reference analog signal to create an amplified analog signal 211.

Method 400 proceeds to 406, where the amplified analog signal is converted into a digitized amplified signal, wherein the digitized amplified signal represents a fine temperature offset from the coarse temperature. In a further implementation, when the at least one analog signal amplifier 210 includes two analog signal amplifier stages, 212 and 214, the monitoring and control device 240 commands a D/A converter 260 to provide the analog offset signal 261 by coupling into the at least one analog amplifier stage between the two analog amplifier stages. The use of a high-resolution D/A converter 260 to provide system calibration and temperature range offset signals limits the amount of components needed to implement and maintain the amplified analog signal 211 within the D/A converter 230 input operating range while greatly improving initial and long-term system accuracy, reliability and flexibility. Further, the combination of the digital offset signal 241, which represents the coarse temperature, and the digitized amplified signal 231, which represents the fine temperature offset from the coarse temperature, are converted into the final temperature measurement.

### Example Embodiments

Example 1 includes a system for sensing and measuring temperature, the system comprising: at least one analog signal amplifier that generates an amplified analog signal output based on an analog signal from at least one of a biased thermistor circuit and a calibration circuit; a digital to analog converter that generates an analog offset signal as an input to the at least one analog signal amplifier, wherein the analog offset signal shifts the amplified analog signal within an analog to digital converter input operating range when the amplified analog signal is equal to or greater than a limit of the analog to digital converter input operating range; and wherein the analog offset signal is determined based on the magnitude of the amplified analog signal.

Example 2 includes the system of Example 1, further comprising a monitoring and control device, wherein the monitoring and control device provides a digital offset signal to control the analog offset signal based on monitoring the amplified analog signal.

Example 3 includes the system of Example 2, further comprising a processor configured to execute software that controls the monitoring and control device.

Example 4 includes the system of any of Examples 2-3, further comprising an analog to digital converter coupled to the at least one analog signal amplifier, wherein the analog to digital converter generates a digitized amplified signal from the amplified analog signal.

Example 5 includes the system of Example 4, wherein the monitoring and control device provides the digital offset signal to control the analog offset signal produced by the digital to analog converter based on the digitized amplified signal.

Example 6 includes the system of any of Examples 2-5, wherein a processor executes software to direct the monitoring and control device to control the digital to analog converter to provide an analog offset signal that shifts the amplified analog signal to a lower limit of the analog to digital converter input operating range when the analog temperature signal is greater than or equal to an upper limit of the analog to digital converter input operating range, and wherein the processor executes the software to command the monitoring and control device to control the digital to analog converter to provide an analog offset signal that shifts the analog temperature signal to the upper limit of the analog to digital converter input operating range when the analog temperature signal is less than or equal to the lower limit of the analog to digital converter input operating range.

Example 7 includes the system of any of Examples 1-6, wherein the at least one analog signal amplifier comprises a first analog signal amplifier stage coupled to a second analog signal amplifier stage, wherein the first analog signal amplifier stage receives an analog signal from at least one of the biased thermistor circuit and the calibration circuit and the output of the first analog signal amplifier stage and the analog offset signal are coupled to a summing junction between the first analog signal amplifier stage and the second analog signal amplifier stage.

Example 8 includes the system of any of Examples 1-7, wherein the biased thermistor circuit comprises a plurality of biased thermistor circuits that are located at different locations and configured to provide different temperature sensing and measurements that correspond with the different locations.

Example 9 includes the system of Example 8, wherein the plurality of thermistors are located at different locations on an electronic device.

Example 10 includes the system of any of Examples 8-9, wherein a processor executes software to command a monitoring and control device to select a first biased thermistor circuit from a plurality of biased thermistor circuits over which an analog signal is selected to provide the analog signal, wherein the processor executes the software to command the monitoring and control device to select the first biased thermistor circuit through a plurality of multiplexors coupled between the plurality of biased thermistor circuits and the at least one amplifier.

Example 11 includes the system of Example 10, wherein the processor executes the software to command the monitoring and control device to select a calibration circuit through the plurality of analog multiplexors, wherein the analog signal produced by the calibration circuit is equivalent to the analog signal produced by the plurality of biased thermistor circuits at a reference temperature.

Example 12 includes a system for measuring temperature, the system comprising: at least one analog signal amplifier that outputs an amplified analog signal corresponding to a temperature reading; a digital to analog converter coupled to the at least one analog signal amplifier, wherein the digital to analog converter produces an analog offset signal from a digital offset signal as an input to the at least one amplifier, wherein the digital offset signal represents a coarse temperature measurement; an analog to digital converter coupled to the at least one analog signal amplifier, wherein the analog to digital converter converts the amplified analog signal within an analog to digital converter input operating range into a digitized amplified signal that represents a fine temperature offset from the coarse temperature; a processor configured to execute software to control the system; and a monitoring and control device coupled to the digital to analog converter, the analog to digital converter and the processor, wherein the processor executes the software to determine a final temperature measurement based on the digital offset signal and the digitized amplified signal, wherein the processor executes the software to command the monitoring and control device to provide the digital offset signal to the digital to analog converter based on the digitized amplified signal, such that the analog offset signal shifts the amplified analog signal within the analog to digital converter input operating range when the amplified analog signal is equal to a limit of the analog to digital converter input operating range or is outside the analog to digital converter input operating range.

Example 13 includes the system of Example 12, wherein the processor executes the software to command the monitoring and control device to provide the digital offset signal to the digital to analog converter to provide the analog offset signal that shifts the amplified analog signal to a lower limit of the analog to digital converter input operating range when the amplified analog signal is greater than or equal to an upper limit of the analog to digital converter input operating range, and wherein the processor executes the software to command the monitoring and control device to provide the digital offset signal to the digital to analog converter to provide an analog offset signal that shifts the amplified analog signal to the upper limit of the analog to digital converter input operating range when the amplified analog signal is less than or equal to the lower limit of the analog to digital converter input operating range.

Example 14 includes the system of any of Examples 12-13, wherein the at least one analog signal amplifier comprises a first analog signal amplifier stage connected to a second analog signal amplifier stage, wherein the first analog signal amplifier stage receives an analog signal from at least one of a biased thermistor circuit and a calibration circuit and the output of the first analog signal amplifier stage and the analog offset signal are coupled to a summing junction between the first analog signal amplifier stage and the second analog signal amplifier stage.

Example 15 includes the system of Example 14, wherein the biased thermistor circuit is one of a plurality of biased thermistor circuits that are located at different locations and configured to provide different temperature measurements that correspond with temperatures at the different locations.

Example 16 includes the system of Example 15, wherein the processor executes the software to command the monitoring and control device to select the biased thermistor circuit in the plurality of biased thermistor circuits to provide an analog signal.

Example 17 includes the system of any of Examples 15-16, wherein the processor executes the software to command the monitoring and control device to select the biased thermistor circuit through a plurality of multiplexors coupled between the plurality of biased thermistor circuits and the at least one analog signal amplifier.

Example 18 includes the system of Example 17, wherein the processor executes the software to command the monitoring and control device to select a calibration circuit through the plurality of multiplexors, wherein the analog signal produced by the calibration circuit is equivalent to the analog signal produced by one of the plurality of biased thermistor circuits at a reference temperature.

Example 19 includes a method for calibrating, sensing and measuring temperature, the method comprising: converting a digital offset signal to an analog offset signal, wherein the digital offset signal represents a coarse temperature measurement and a calibration offset, the analog offset signal offsets an amplified analog signal to keep the amplified analog signal within an analog to digital converter input operating range; amplifying an analog signal with at least one analog signal amplifier to produce the amplified analog signal based on the analog signal from at least one of a biased thermistor circuit and a calibration circuit; and converting the amplified analog signal into a digitized amplified signal, wherein the digitized amplified signal represents a fine temperature offset from the coarse temperature offset and calibration offset.

Example 20 includes the method of Example 19, wherein the analog offset signal shifts the amplified analog signal to a lower limit of the analog to digital converter input operating range when the amplified analog signal is greater than or equal to an upper limit of the analog to digital converter input operating range, and the analog offset signal shifts the amplified analog signal to the upper limit of the analog to digital converter input operating range when the amplified analog signal is less than or equal to the lower limit of the analog to digital converter input operating range.

Although specific embodiments have been illustrated and described herein, it will be appreciated by those of ordinary skill in the art that any arrangement, which is calculated to achieve the same purpose, may be substituted for the specific embodiments shown. Therefore, it is manifestly intended that this invention be limited only by the claims and the equivalents thereof.

## Claims

1. A system for sensing and measuring temperature, the system comprising:
at least one analog signal amplifier (110) that generates an amplified analog signal (116) output based on an analog signal (152) from at least one of a biased thermistor circuit (154) and a calibration circuit (156);
a digital to analog converter (160) that generates an analog offset signal (161) as an input to the at least one analog signal amplifier (110), wherein the analog offset signal (161) shifts the amplified analog signal (116) within an analog to digital converter input operating range when the amplified analog signal (116) is equal to or greater than a limit of the analog to digital converter input operating range; and
wherein the analog offset signal (161) is determined based on the magnitude of the amplified analog signal (116).

2. The system of claim 1, further comprising a monitoring and control device (140), wherein the monitoring and control device (140) provides a digital offset signal (141) to control the analog offset signal (161) based on monitoring the amplified analog signal (116).

3. The system of claim 2, wherein a processor (120) executes software to direct the monitoring and control device (140) to control the digital to analog converter (160) to provide an analog offset signal (161) that shifts the amplified analog signal (116) to a lower limit of the analog to digital converter input operating range when the analog temperature signal is greater than or equal to an upper limit of the analog to digital converter input operating range, and wherein the processor (120) executes the software to command the monitoring and control device (140) to control the digital to analog converter (160) to provide an analog offset signal (161) that shifts the analog temperature signal to the upper limit of the analog to digital converter input operating range when the analog temperature signal is less than or equal to the lower limit of the analog to digital converter input operating range.

4. The system of claim 1, wherein the at least one analog signal amplifier (110) comprises a first analog signal amplifier stage (212) coupled to a second analog signal amplifier stage (214), wherein the first analog signal amplifier stage (212) receives an analog signal (251) from at least one of the biased thermistor circuit (258) and the calibration circuit (256) and the output of the first analog signal amplifier stage (212) and the analog offset signal (261) are coupled to a summing junction between the first analog signal amplifier stage (212) and the second analog signal amplifier stage (214).

5. The system of claim 1, wherein the biased thermistor circuit (154) comprises a plurality of biased thermistor circuits that are located at different locations and configured to provide different temperature sensing and measurements that correspond with the different locations.

6. The system of claim 5, wherein the plurality of thermistors are located at different locations on an electronic device.

7. The system of claim 5, wherein a processor (120) executes software to command a monitoring and control device (140) to select a first biased thermistor circuit from a plurality of biased thermistor circuits over which an analog signal is selected to provide the analog signal (152), wherein the processor executes the software to command the monitoring and control device (140) to select the first biased thermistor circuit through a plurality of multiplexors (252, 254) coupled between the plurality of biased thermistor circuits and the at least one amplifier (110).

8. The system of claim 7, wherein the processor (120) executes the software to command the monitoring and control device (140) to select a calibration circuit (256) through the plurality of analog multiplexors (252, 254), wherein the analog signal (152) produced by the calibration circuit (156) is equivalent to the analog signal (152) produced by the plurality of biased thermistor circuits (154) at a reference temperature.

9. A method for calibrating, sensing and measuring temperature, the method comprising:
converting a digital offset signal (141) to an analog offset signal (161), wherein the digital offset signal (141) represents a coarse temperature measurement and a calibration offset, the analog offset signal (161) offsets an amplified analog signal (116) to keep the amplified analog signal (116) within an analog to digital converter input operating range;
amplifying an analog signal (152) with at least one analog signal amplifier (110) to produce the amplified analog signal (116) based on the analog signal (152) from at least one of a biased thermistor circuit (154) and a calibration circuit (156); and
converting the amplified analog signal (116) into a digitized amplified signal (132), wherein the digitized amplified signal (132) represents a fine temperature offset from the coarse temperature offset and calibration offset.

10. The method of claim 9, wherein the analog offset signal (161) shifts the amplified analog signal (116) to a lower limit of the analog to digital converter input operating range when the amplified analog signal (116) is greater than or equal to an upper limit of the analog to digital converter input operating range, and the analog offset signal (161) shifts the amplified analog signal (116) to the upper limit of the analog to digital converter input operating range when the amplified analog signal (116) is less than or equal to the lower limit of the analog to digital converter input operating range.
